# EUROPEAN PATENT APPLICATION

(11) **EP 4 414 482 A1**
(43) Date of publication of application: **14.08.2024**
(21) Application number: 23155282.9
(22) Date of filing: 07.02.2023
(51) Int. Cl.: C30B 29/20, C30B 29/32, C30B 33/06

(54) **COMPOSITE SUBSTRATES FOR THE EPITAXIAL GROWTH OF THIN FILMS AND METHOD FOR FABRICATING SUCH SUBSTRATES**

(71) Applicant: Max-Planck-Gesellschaft zur Förderung der Wissenschaften e.V., 80539 München (DE)
(72) Inventor: HARBOLA, Varun, 70569 Stuttgart (DE); MANNHART, Jochen, 71032 Böblingen (DE)
(74) Representative: Lambsdorff & Lange Patentanwälte Partnerschaft mbB

(57) **Abstract**

A method for fabricating a composite substrate (10) which comprises
- providing a first crystalline layer (2);
- providing a carrier (5);
- fabricating a composite substrate (10) by attaching the first crystalline layer (2) on the carrier (5).

## Description

### TECHNICAL FIELD

The present disclosure relates in general to the field of fabricating epitaxial crystalline layers on substrates.

### BACKGROUND

Thin films grown epitaxially on substrates are ubiquitous in technology. Epitaxial growth usually requires the films to be deposited on substrates that meet stringent requirements, however. For example, the crystal systems and lattice constants of substrate and film need to match. Further, the substrate and the film need to be chemically compatible. These reasons often demand the use of costly substrates. Substrates are usually expensive as they are typically single crystals cut from crystals boules with subsequent orientation and polishing steps. In cases where several films with different lattice constants need to be grown, an equal number of different substrates may be needed. Further, in some cases the material properties of the substrate do not match the requirement of a final device application. For example, for epitaxial growth of thin films, only insulating substrates may be available, whereas a device application may require a metallic or conducting substrate to carry the film.

To cut costs substrates are sometimes recycled after use by repolishing. The recycling process is costly and cumbersome and the number of repolishing cycles is limited, however, due to the reduction of the substrate thickness inherent to each polishing step.

### REFERENCES

K. Khang et al., 'Layer-by-layer assembly of two-dimensional materials into wafer-scale heterostructures', Nature 550, 229 (2017)
H. Kim et al., 'Remote epitaxy', Nature Reviews 2:40 (2022) H.S. Kum et al. 'Heterogeneous integration of single-crystalline complex-oxide membranes', Nature 578, 75 (2020) K. Lee et al., 'Systems and methods for fabricating semiconductor devices via remote epitaxy', US 2020/0043790 A1 D. Lu et al., 'Synthesis of freestanding single-crystal perovskite films and heterostructures by etching of sacrificial water-soluble layers', Nat. Mater. 15, 1255 (2016)
A.J. Mannix et al., 'Robotic four-dimensional pixel assembly of van der Waals solids', Nature Nanotechnology 17, 361 (2022)
Y. Shiohara et al., 'Overview of Materials and Power Applications of Coated Conductors Project', Japanese Journal of Applied Physics 51 (2012) 010007

### STATE OF THE ART

### COATED CONDUCTOR TECHNOLOGY

An approach to solve the problem has been developed and is used for the growth of high-Tc superconductors of the 123 family on polycrystalline Ni or steel tapes. In this so called coated conductor technology, a buffer layer system is deposited first on the Ni or steel tape. Crystalline alignment is induced into this buffer layer system, for example by supplying the Ni tape with an oriented surface structure obtained by rolling the tape prior to the deposition, or by irradiating the buffer layer during its growth with an ion beam under an oblique angle [Shiohara, 2012]. As a result, the high-Tc superconductor grown atop the buffer layer is polycrystalline with a grain alignment of a few degrees. This method has the disadvantage that the films grown in this manner are not of very good, single crystalline quality. Further, the procedure presented is material specific to films of the 123 cuprate family and to Ni or steel tapes, for which it took years and enormous investment to develop.

While the following three technologies have not been used to solve the problem presented, they nevertheless comprise state-of-the-art that is some aspects is relevant for the current invention.

### STACKING OF 2D MATERIALS

So-called 2D materials such as graphene or transition-metal-dichalcogenides consist of sheets that are only one or few atomic layers thick (i.e. 2D layers). Stacks of such sheets are bound only weakly together by van-der-Waals forces. It is now common practice to stack such 2D-layers sequentially by micromechanical exfoliation, transfer, orientation and mechanical mounting in a layer-by-layer assembly process. This process has even been automated using robotic assembly [Mannix, 2022]. This assembly process is frequently used to fabricate heterostructures of van-der-Waals materials [Khang, 2017].

### REMOTE EPITAXY

In remote epitaxy [Lee, 2020; Kim, 2022], a first substrate is covered by a sheet of a so-called 2D-material, such as graphene. Upon this sheet another material is grown that epitaxially aligns with the first substrate. As the graphene layer can be peeled off from the substrate, the epitaxially grown layer can be mechanically transferred as a freestanding membrane to a second substrate such as a semiconducting chip, on which the membrane is mounted to achieve a desired function. Further, onto such deposited 2D-layers, further 2D-layers can be mounted after mechanical transfer. To the best of our knowledge, no further films have been then epitaxially grown on the 2D layers or membranes after their transfer to the second substrate.

### FREESTANDING OXIDE MEMBRANES

For the fabrication of freestanding oxide membranes, thin films of a sacrificial release material are epitaxially grown onto a first substrate. A multitude of further films is then epitaxially deposited onto this release layer. The material of the sacrificial release film is chosen to be soluble in a solvent such as water or an acid [Lu, 2016]. Therefore, by dissolving the release layer, the epitaxially grown further films can be lifted off as freestanding membranes to be mechanically transferred to and mounted onto a second substrate on which they are used to achieve a desired function.

For these and other reasons there is a need for the present disclosure.

### SUMMARY

The present disclosure makes it possible to avoid the need for difficult to obtain or expensive single crystals as substrates for the growth of thin films. In particular the present disclosure makes it possible to epitaxially grow films on substrates that, for example due to their material composition, lattice structure or shape, are by themselves not suitable to serve as substrates for the epitaxial growth of said film.

One aspect of the present disclosure is related to a method for fabricating a composite substrate, the method comprising providing a first crystalline layer, providing a carrier, fabricating a composite substrate by attaching the first crystalline layer on the carrier.

According to an embodiment of the method for fabricating a composite substrate, the method further comprises epitaxially depositing a second crystalline layer onto the first crystalline layer of the composite substrate. The first crystalline layer thus fulfils the function of a template layer for the subsequent epitaxial growth of the second crystalline layer.

According to an embodiment of the method for fabricating a composite substrate, providing the first crystalline layer comprises providing a master substrate, depositing the first crystalline layer above the master substrate, and separating the first crystalline layer from the master substrate.

According to an embodiment of the method for fabricating a composite substrate the method further comprises fabricating a plurality of composite substrates by repeatedly re-using one and the same master substrate for fabricating a plurality of first crystalline layers and subsequently attaching the plurality of first crystalline layers on a corresponding plurality of carriers.

According to an embodiment of the method for fabricating a composite substrate, the method further comprises depositing a release layer on the master substrate and subsequently depositing the first crystalline layer on the release layer, wherein separating the layer stack from the master substrate comprises removing the release layer.

According to an embodiment of the method for fabricating a composite substrate, providing a first crystalline layer comprises providing a layer stack comprising a support layer and a first crystalline layer attached to the support layer, and fabricating a composite substrate comprises attaching the layer stack on a carrier.

According to another embodiment of the invention said layer stack is cut, divided, or split into several parts of smaller areas that then are used to fabricate a multitude of composite substrates.

According to an embodiment of the method for fabricating a composite substrate, the method comprises disposing one or both of an adhesion layer and a blocking layer on the carrier and thereafter attaching the first crystalline layer or the layer stack on the adhesion layer or the blocking layer.

A further aspect of the present disclosure is related to a composite substrate comprising a carrier, and a first crystalline layer attached to the carrier, a material of the first crystalline layer being different from a material of the carrier.

According to an embodiment of the composite substrate, the composite substrate further comprises an adhesion layer disposed between the carrier and the first crystalline layer.

According to an embodiment of the composite substrate, the composite substrate further comprises a blocking layer disposed between the carrier and the first crystalline layer and configured to reduce interdiffusion of atomic species or electronic or magnetic interactions between the carrier and the first crystalline layer.

According to an embodiment of the composite substrate, the composite substrate further comprises a second crystalline layer epitaxially grown on the first crystalline layer.

According to an embodiment of the composite substrate, the first and second crystalline layers comprise identical or similar materials.

A further aspect of the present disclosure is related to a method for providing a crystalline layer, the method comprising providing a master substrate, depositing a crystalline layer above the master substrate, and separating the crystalline layer from the master substrate.

According to an embodiment of the method for providing a crystalline layer, the method further comprises depositing a release layer on the master substrate and subsequently depositing the crystalline layer on the release layer, and separating the crystalline layer from the master substrate by removing the release layer.

According to an embodiment of the method for providing a crystalline layer, the method further comprises fabricating a layer stack by disposing a support layer on the crystalline layer, wherein separating the crystalline layer comprises separating the layer stack from the master substrate.

According to an embodiment of the method for providing a crystalline layer, disposing the crystalline layer comprises choosing a material of the crystalline layer based on one or more of an internal requirement, a personal wish by someone, an external requirement, an order or a request of a friend, business partner or customer.

According to an embodiment of the method for providing a crystalline layer, the method further comprises handing over or delivering the separated crystalline layer or layer stack to one or more of a person, entity, or customer who had placed the order or request.

According to an embodiment of the method for providing a crystalline layer, depositing the release layer comprises epitaxially depositing the release layer onto the master substrate.

According to an embodiment of the method for providing a crystalline layer, depositing the crystalline layer comprises epitaxially depositing the crystalline layer on the master substrate or on the release layer.

According to an embodiment of the method for providing a crystalline layer, a thickness of the crystalline layer is in a range from 1 crystalline unit cell to 500 nm or from 1 nm to 50 nm or from 5 nm to 50 nm.

### BRIEF DESCRIPTION OF THE DRAWINGS

The accompanying drawings are included to provide a further understanding of embodiments and are incorporated in and constitute a part of this specification. The drawings illustrate embodiments and together with the description serve to explain principles of embodiments. Other embodiments and many of the intended advantages of embodiments will be readily appreciated as they become better understood by reference to the following detailed description.

The elements of the drawings are not necessarily to scale relative to each other. Like reference numerals designate corresponding similar parts.
Fig. 1 shows schematic cross-sectional side views to illustrate an example of a method for fabricating a crystalline layer according to one aspect.
Fig. 2 shows schematic cross-sectional side views to illustrate an example of a method for fabricating a composite substrate according to a further aspect.
Fig. 3 shows schematic cross-sectional side views to illustrate a further example of the method for fabricating a composite substrate according to Fig. 2, which further example shows the fabrication of a plurality of composite substrates by using a conventional substrate as master substrate.
Fig. 4 shows schematic cross-sectional side views to illustrate a further example of the method for fabricating a composite substrate according to Fig. 2, which further example shows the fabrication of a plurality of composite substrates by using a composite substrate as master substrate.
Fig. 5 shows a photograph of an exemplary composite substrate.

### DESCRIPTION OF EMBODIMENTS

In the following detailed description, reference is made to the accompanying drawings, which form a part hereof, and in which is shown by way of illustration specific embodiments in which the disclosure may be practiced. In this regard, directional terminology, such as "top", "bottom", "front", "back", "leading", "trailing", etc., is used with reference to the orientation of the Figure(s) being described. Because components of embodiments can be positioned in a number of different orientations, the directional terminology is used for purposes of illustration and is in no way limiting. It is to be understood that other embodiments may be utilized and structural or logical changes may be made without departing from the scope of the present disclosure. The following detailed description, therefore, is not to be taken in a limiting sense, and the scope of the present disclosure is defined by the appended claims.

It is to be understood that the features of the various exemplary embodiments described herein may be combined with each other, unless specifically noted otherwise.

As employed in this specification, the terms "bonded", "attached", "connected", "coupled" and/or "electrically connected/electrically coupled" are not meant to mean that the elements or layers must directly be contacted together; intervening elements or layers may be provided between the "bonded", "attached", "connected", "coupled" and/or "electrically connected/electrically coupled" elements, respectively. However, in accordance with the disclosure, the above-mentioned terms may, optionally, also have the specific meaning that the elements or layers are directly contacted together, i.e. that no intervening elements or layers are provided between the "bonded", "attached", "connected", "coupled" and/or "electrically connected/electrically coupled" elements, respectively.

Further, the terms "on", "over" or "above" used with regard to a part, element or material layer formed or located "on, "over" or "above" a surface may be used herein to mean that the part, element or material layer be located (e.g. placed, formed, deposited, etc.) "indirectly on" the implied surface with one or more additional parts, elements or layers being arranged between the implied surface and the part, element or material layer. However, the above terms used with regard to a part, element or material layer formed or located "on", "over" or "above" a surface may, optionally, also have the specific meaning that the part, element or material layer be located (e.g. placed, formed, deposited, etc.) "directly on", e.g. in direct contact with, the implied surface.

### DETAILED DESCRIPTION

The following description will show in greater detail how the problem of circumventing the use of costly substrates is solved.

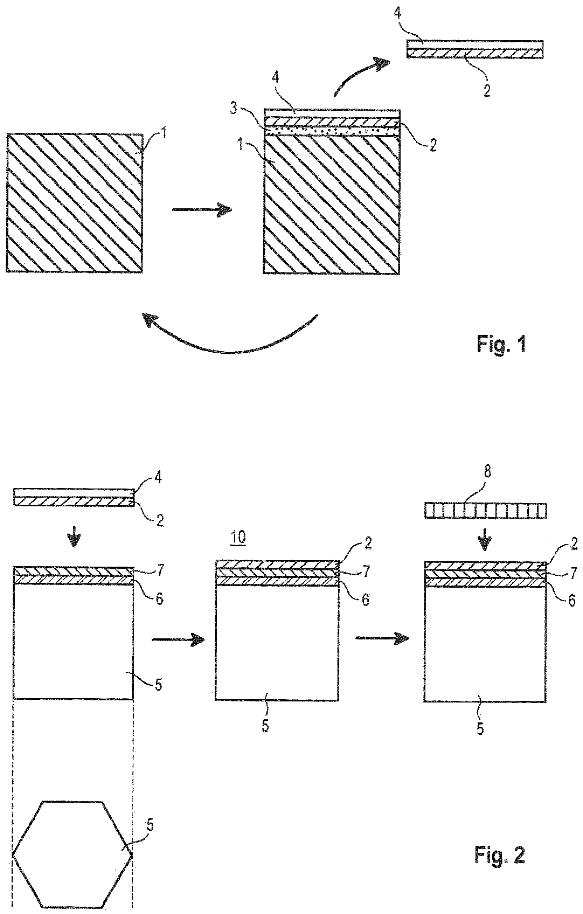

Fig. 1 shows schematic cross-sectional side views to illustrate an example of a method for fabricating a crystalline layer according to one aspect of the present disclosure. The crystalline layer will fulfil the function of a template layer in the subsequent steps.

The solution is based on the understanding that of a substrate only a few-nm-thick surface layer is actually needed as a requisite for epitaxial growth. It is only this layer that needs to be comprised of a costly material with a desired lattice symmetry and lattice parameter values. The rest of the typically 0.5-1 mm thick substrate bears no function for the epitaxial growth process, except for acting as a suitable carrier for the surface layer. Therefore - 99.999 % of the mass of a substrate does not contribute to the epitaxial growth process, but generates a large fraction of the substrate cost.

The solution is furthermore based on the understanding that layers with a thickness of a few nm can be readily grown in high quality by standard epitaxial growth processes such as molecular beam epitaxy, pulsed laser deposition, or other well-known film deposition procedures.

Therefore, it is feasible to fabricate the desired crystalline surface layer 2 by epitaxial deposition of a thin film on a substrate 1 of choice ('master substrate' 1). According to the example as shown in Fig. 1, this thin film 2 is, however, not deposited directly on this master substrate 1, but rather on a sacrificial release layer 3 which has been deposited before onto said master substrate 1.

Optionally a support layer 4 can be attached on the crystalline layer 2 thereby forming a layer stack comprising the crystalline layer 2 and the support layer 4. The support layer 4 would facilitate the later removing of the crystalline layer 2 from the master substrate 1. However, the support layer 4 can also be omitted depending on the nature, in particular the thickness, of the crystalline layer 2.

Later on, for removing the crystalline layer 2 the sacrificial release layer 3 can be removed and the crystalline layer 2 can be transferred to a carrier for fabricating a composite substrate by a user which will be shown later in connection with Fig. 2.

It is furthermore noted that after the release of the crystalline layer 2, the master substrate 1 can be recycled by refurbishing its surface (indicated by the large arrow), for example by laser heating to temperatures that yield appreciable surface diffusion. Therefore the master substrate 1 is not consumed in the process. It is preserved and can be used in a cyclic manner, yielding a corresponding reduction of the cost of the thin film growth process. But, of course, it would nevertheless be also possible to refurbish the master substrate by chemical cleaning, etching, polishing, or similar steps.

According to an example, the master substrate 1 can be comprised of a single crystal material as, for example, a 1-mm-thick, [001] oriented SrTiO₃ single crystal or 0.5-mm-thick, [001] oriented DyScO₃ single crystal. The master substrate may also be a bicrystal or a polycrystal or an amorphous compound, such that bicrystalline or polycrystalline or amorphous templates are obtained that then can serve for the epitaxial growth of respective films.

According to a further example, composite substrates as fabricated according to Fig. 2 can also be used as master substrates in further growth processes.

According to a further example, several templates may be deposited onto a carrier substrate by laterally stitching. In this case, the carrier substrate can be very large as its surface layer may consist of an array of stitched templates. Stitched patches may be deliberately oriented or patterned, e.g., in different in-plane orientations. Further, the stitched patches may consist of different materials or comprise different lattice structures.

According to a further example, in the ideal case, the crystal lattice symmetry and the lattice parameters of the master substrate are identical to those of the epitaxial film 8 to be grown later by the user. If the lattice constants differ, the release layer may be used to bridge that difference.

According to a further example, the template layer is grown to a thickness that exceeds its critical thickness for stress relaxation. By this, the lattice constants of the top and bottom surfaces of the template layer may differ, such that the top surface lattice constant is more ideally suited for the later epitaxial growth of the film 8 by the user.

According to an example, the material of the release layer 3 can be, for example, Sr₃Al₂O₆, Sr₂CaAl₂O₃, Sr_{3- x}CaₓAl₂O₃ (=solid solution), soluble manganites or nickelates. Crystal lattice and lattice parameter in the ideal case are identical or similar to that of the epitaxial film 2 to be grown by the user. The release layer 3 may consist of a solid solution: the lattice parameter is then adjustable by choosing the composition of the solid solution. In case the lattice constants of the release layer 3 match the one of the epitaxial film 8 to be grown by the user, but not the ones of the master substrate 1, the release layer 3 may be grown to a thickness exceeding its critical thickness so that the strain of the mismatching lattices is compensated by a dislocation layer. In case the material of the release layer 3 consists of a solid solution, its composition may furthermore be varied during its growth to bridge the difference of the constants of the master substrate 1 and the crystalline layer 8 to be grown epitaxially by the user. The release layer 3 may also be given by a van-der-Waals material that can, for example, be released by peeling.

It should be mentioned at this point that use of a release layer 3 is also only optional. At least for some materials, other processes are conceivable as an alternative to a release layer. The removal of the crystalline layer 2 from the master substrate 1 can in particular be accomplished by other release mechanisms like, for example, by spalling or by injection of hydrogen into the sample.

According to a further example, at least one blocking layer 7 can be deposited on or above the master substrate 1. The function of the blocking layer 7 will be explained later. If a release layer 3 is used, the at least one blocking layer 7 will be deposited on the release layer 3 and subsequently the first crystalline layer (2) will deposited on or above the blocking layer 7.

According to an example, the material of the support layer 4 can be, for example, one or more of a polymer or a varnish. It should be suitable for release so that a clean surface of the crystalline layer 2 can be obtained. The support layer 4 may also be glued to the crystalline layer 2 by a glue that can be removed later by a suitable gas atmosphere.

According to an example, the material of the crystalline layer 2 can be, for example, made of the material of the film to be later grown epitaxially by the user, e.g., SrTiO₃ or DyScO₃. The crystalline layer 2 can have a thickness ranging from 1-unit-cell to 500-nm-thick, preferred 5-50 nm (depending on material and application). It can be, for example, a 10-nm-thick, [001] oriented SrTiO₃ film or a 25-nm-thick, [001] oriented DyScO₃. The crystalline layer 2 may comprise any material that can be grown with the crystalline structure desired for the epitaxial film 8 of the user (in most cases preferably single-crystalline) on a dissolvable release layer 3 as, for example, a perovskites, spinels, oxides, nitrides, carbides, or 2D materials.

According to an example, the crystalline layer 2 may differ in composition (e.g. doping) from the master substrate 1 or from the carrier 5. The crystalline layer 2 may itself be a multilayer and carry a film for later use in application. While the crystalline layer 2 is in many cases grown epitaxially and as a single-crystalline layer on the master substrate, it may for some applications be preferable that its growth is not epitaxial or that the crystalline layer 2 comprises several crystals, or even has a polycrystalline or amorphous structure.

Because the crystalline layer 2 is grown in a thin film deposition process, it may contain less impurities than a bulk single crystal of the same compound that is conventionally used as a substrate. If the master substrate 1 has been fabricated by using the process as presented above, the crystalline layer 2 may also contain fewer defects (for example fewer dislocations) than a bulk single crystal of the same compound.

Fig. 2 shows schematic cross-sectional side views to illustrate an example of a method for fabricating a composite substrate according to a further aspect. The hexagon at the bottom left presents an example of a possible top view of the carrier to illustrate that the carrier may be of almost arbitrary cross sectional shape.

By dissolving the release layer 3 as was explained above in connection with Fig. 1, the crystalline layer 2 can be removed from the master substrate 1 and be transferred to a carrier material of choice ('carrier' 5). This carrier material does not need to meet the constraints for the epitaxial growth of a film 8. Therefore it can be far less costly or be optimized further as compared to the master substrate 1.

The gist of the invention is given by the fact that the carrier with the template layer on its surface, the combination of the two is called 'composite substrate', can be handled and used like a conventional substrate. The obtained composite substrate may even be used as a master substrate in further growth steps.

The invention therefore abandons the need to use for the epitaxial growth of a thin film a costly master substrate. Instead, one master substrate can be used to fabricate a large number of less costly composite substrates of which only the top surface is optimized for epitaxial deposition. By this, a large number of epitaxial film depositions are achieved by the use of epitaxial imprints of the surface the master substrate and by fixing these imprints as coatings onto suitable, cheap carriers to serve as a functional template for the desired epitaxial growth. The invention therefore presents a method to equip for epitaxial growth a carrier of choice with a surface of choice.

As shown in Fig. 2, a layer stack comprising the crystalline layer 2 and a support layer 4 is attached to the carrier 5. As mentioned before, the support layer 4 is optional and can be omitted depending on the configuration, in particular the thickness of the crystalline layer 2. Before attaching the layer stack an adhesion layer 6 and a blocking layer 7 can be deposited on the carrier 5 or on the crystalline layer 2.

The material of the carrier 5 can be an elemental or a compound semiconductor, oxide (e.g. sapphire), nitride (e.g. BN), carbide, diamond, glass, polymer, semiconducting die or chip or circuit, or preexisting object to be coated (Ti-part for human body, cable, steel rod, ...). It can be a material with advantageous properties for later epitaxial growth (thermal stability, absorption of heating laser beam, machinability) or a material with advantageous properties for intended use, e.g., high or low thermal conduction, high mechanical strength, elasticity (e.g., to enable flipping between concave and convex shapes), magnetic properties, electrically conducting, ferroelectric, piezoelectric, superconducting, low noise (small defect density, optimal dielectric properties), low rf loss angle. The carrier may, for example, be an optical element such as a convex optical glass lens, onto which by means of the template layer deposition, further layers can be grown epitaxially as single crystalline materials to obtain preferable properties (optical, mechanical, electronic etc.).

Of the composite substrate, the stacking structure including the carrier may be chosen such that, for example by means of a piezoelectric layer, local or global modifications of the lattice constants of the template layer may be achieved. Such adaptions may be useful for locally or globally tuning the surface of the template layer 2 to optimize the later growth of the layer 8.

Concerning the lattice structure the carrier 5 may have a different lattice structure than the film 8 to be grown. It may, *e.g*., be single crystalline, polycrystalline, or amorphous, *e.g*., glass. Carriers 5 may be used that have a different thermal expansion behavior than the template layer 2 to have compressively or tensilely strained template layers at the growth temperature of the subsequent epitaxial structures.

Concerning the architecture the carrier 5 may itself comprise a heterostructure. The carrier 5 may be structured, pre-patterned, provided with holes, channels, (embedded) conducting lines, mechanical devices, electronic devices, chemical devices, etc.

Concerning the shape the carrier 5 can be larger (or smaller) than the crystalline layer 2, may have a complex shape, *e.g.*, planar hexagon (example thereof is shown in the lower part of Fig. 2), concave or convex (mirrors, rfcavities, coatings of lenses, also to apply stress or strain), surface ripples, arrays of surface pimples etc. The carrier shape may also be actively tuned, for example by applying an electric field across a piezoelectric carrier. The carrier surface does not need to be as well polished as is usually required for good epitaxial growth

The carrier 5 and/or the crystalline layer 2 may be covered with a thin adhesion layer 6 that strengthens the adhesion between both. Induced by a heating process, the adhesion layer 6 may 'solder' or 'weld' the crystalline layer 2 and the carrier 5 together, *e.g*., by forming, *e.g*., an eutectic solution. The adhesion layer may also serve to function as a diffusion or conduction path to conduct to the environment humidity or further materials such as gases or liquids that have been trapped during the fabrication process between the carrier and the template layer, or to absorb these materials within the adhesion layer.

In case of sapphire substrate as carrier 5 the adhesion layer 6 may comprise a 5-nm-thick layer of amorphous SrTiO₃ deposited onto the sapphire substrate and heated to 600 °C for 10 minutes to foster the bonding to a then transferred SrTiO₃ template.

For some applications, the carrier 5 may exert unwanted effects on the crystalline layer 2 or on the film to be grown epitaxially. These effects may comprise interdiffusion of atoms or electronic or magnetic interactions. A blocking layer 7 deposited between the carrier 5 and the crystalline layer 2 or on the surface of the crystalline layer 2 can be used to minimize these effects. The blocking layer 7 is chosen to have a low diffusivity for the possibly diffusing unwanted atom species, or be electrically conducting or superconducting, or have a high magnetic permeability to electromagnetically shield the film 8 to be grown epitaxially from the carrier. As was explained above, the blocking layer 7 can also be fabricated in an earlier stage.

One aspect of the present disclosure is directed to a composite substrate. An example of such a composite substrate 10 is shown in the middle part of Fig. 2. The composite substrate 10 of Fig. 2 comprises a carrier 5, an adhesion layer 6 disposed on the carrier 5, a blocking layer 7 disposed on the adhesion layer 6, and a crystalline layer 2 (template) disposed on the blocking layer 7. The crystalline layer 2 may also be draped over the edges of the carrier 5. The order of the adhesion layer 6 and the blocking layer 7 can also be reversed. As already mentioned, the adhesion layer 6 and the blocking layer 7 can also be omitted. The composite substrate 10 may also be surface treated and/or terminated, e.g. by (laser) heating.

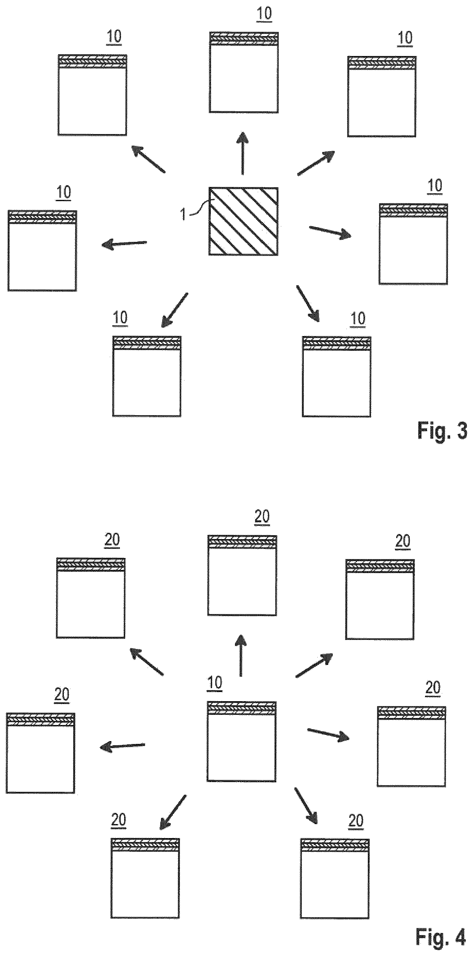

Figs. 3 and 4 show schematic cross-sectional side views to illustrate further examples of the method for fabricating a composite substrate according to Fig. 2. Illustrated is in both Figures the use of a single master substrate to fabricate many composite substrates without consuming or altering the master substrate.

Fig. 3 shows the fabrication of a plurality of composite substrates 10 by using a conventional substrate 1 as master substrate 1.

Fig. 4 shows the fabrication of a plurality of composite substrates 20 by using a composite substrate 10 as master substrate 10.

The whole process as shown in Figs. 1 and 2 can be carried out by a single entity, e.g. a company or scientific institute or whatever. However, at this point it should be mentioned that the process can also be carried out by at least two different entities. In particular, the method of fabricating a crystalline layer as shown and described in connection with Fig. 1 can be carried out by a first entity, and the method of fabricating a composite substrate as shown and described in connection with Fig. 2 can be carried out by a second entity which is different from the first entity. The first entity may carry out the method of Fig. 1 without any external input, e.g. by choosing a material of the crystalline layer 2 based on an internal requirement or a personal wish by someone or due to an external requirement, an order or a request by a friend, business partner or customer. In particular, it is possible that the second entity carrying out the method of Fig. 2 acts as a customer of the first entity, e.g. by sending an order to the first entity to fabricate one or more crystalline layers 2 of a particular material, and receiving the crystalline layers 2 to fabricate composite substrates 10 thereof. It is even possible that the second entity does not carry out the epitaxial growth of the crystalline layer 8, but instead hands out the fabricated composite substrates to a third entity which acts as the final processor of the delivered composite substrates 10.

Examples for the film deposition technique which may be used to grow the release layer, template layer, support layer, adhesion layer, or blocking layer are thermal laser epitaxy, sputtering, MOCVD, pulsed-laser deposition, or spin coating.

Concerning the crystalline layer 2, to select the lattice parameters of the crystalline layer 2 to match precisely the desired value (in most cases the lattice constant of the film to be grown by the user of Fig. 2), the composition of a material system that forms solid solution compounds can be selected. The lattice parameters may even be softwarecontrolled, by implementing a computer-controlled process (*e.g*., thermal laser epitaxy). The crystalline layer 2 may also be fabricated by remote epitaxy.

Concerning the release layer 3, speed of release is a critical parameter for mass production, in case of chemical dissolution of the release layer a short dissolution time may be preferable. The following release layer properties are important for short dissolution time: material, thickness, and microstructure. The important control parameters for the dissolution time for release by wet chemical etching are, *e.g*., the solvent composition, T, P, and pH value. For release by vapor phase etching, *e.g*., reactive ion etching, *e.g.,* vapor composition, T, and P are the important control parameters. The crystalline layer 2 may be vacuum-dried after its release.

Onto a first release layer and a first crystalline layer, further release layers and crystalline layers may be grown.

Concerning the release of the support layer 4, conceivable are e.g., release by heating, by dissolution, or by oxidation, *e.g*., in a plasma, in case a glue has been used change of atmosphere to release the glue.

Mounting of the crystalline layer 2 on the carrier 5 can be performed, *e.g*., in vacuum, with in-situ heating, to obtain clean surfaces, and/or *e.g*., by using a heating step and/or an adhesion layer. The crystalline layers 2 may be mounted with any desired alignment angle between the crystal layer 2 and the carrier 5. The crystalline layers 2 may be mounted at elevated or lowered temperatures on the carriers 5 or on mechanically pre-stressed carriers (uniaxially or isotropically) to create a crystalline layer 2 that is deliberately strained at room temperature or at the deposition temperatures of subsequent layers.

In case the carrier 5 is larger than the crystal layer 2, the crystal layers 2 may be mounted at a desired location on the carrier 5. A multitude of crystal layers 2 of different materials, shapes, etc. may be mounted on one carrier, with lateral separation, stitching, overlap, or stacking.

Concerning the preparation of the composite substrate 10 for the growth of the epitaxial film 8, the surface of the composite substrate 10 may be annealed to remove defects and to turn it atomically flat by subjecting the composite substrate 10 to a thermal anneal. This anneal is preferably performed in-situ, and, *e.g*., generated by laser heating. For a SrTiO₃ crystal layer 2, an anneal step of 1300 °C and 5 min. may be chosen. A similar anneal step may be performed to terminate the surface of the composite substrate 10 such that it comprises one well-defined atomic layer. A TiO₂ termination of a SrTiO₃ crystal layer 2 may also be achieved by an anneal of 1300°C and 5 min.

Refurbishing of the master substrate 1, can be done e.g., by laser heating, e.g., with a CO2 laser to 1300°C for 10 min (preferred), by mechanical polishing (not preferred, because polishing is a subtractive process), or by epitaxy, in particular homoepitaxy.

Concerning refurbishing used composite substrates 10, the composite substrate 10 can be re-polished or alternatively be reused by simply adding a further crystalline layer.

At least parts of the process may be continuous (*e.g. for coated conductor fabrication*). Further, process parts may be parallelized for batch fabrication of identical composite substrates or libraries of composite substrates with range of properties (different carrier materials, carrier shapes, template materials ...), could be performed in vacuum, air, in liquids, or controlled atmospheres, or may be automated, robotized (*e.g*., mounting the membrane on the carrier), and computer controlled.

Composite substrates have preferable properties as compared to flakes of crystalline layers. They are, *e.g*., more practical to handle. It is more easy to heat them controllably. The properties of the membranes and of the composite substrates can be obtained with higher reproducibility than those of standard single crystal substrates, the properties of which vary due to the growth processes of the single crystals. Further, the surface orientation (vicinal cut) is reproducible.

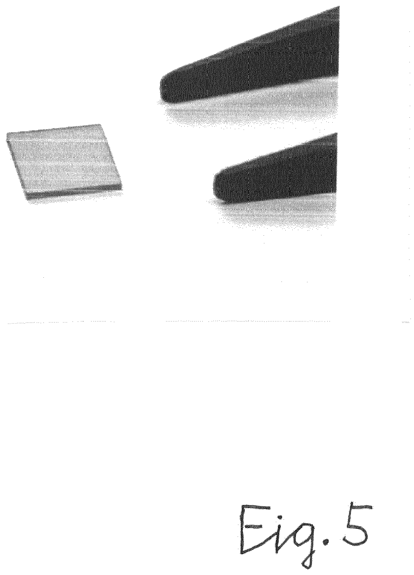

Fig. 5 shows a photograph of an exemplary composite substrate.

The carrier 5 consists of a sapphire crystal. Onto the (0001) surface of the carrier 5 a 20-nm-thick <100> oriented SrTiO₃ template layer 2 has been deposited. Onto this composite substrate 10 a 24-nm-thick La _{0.67}Sr_{0.33}MnO₃ film 8 has been grown by the user epitaxially by pulsed laser deposition (at 700 C in 0.1 mbar O₂ at 1 Hz of irradiation with a 248 nm excimer laser beam at a fluence of 2.3 J/cm²). The SrTiO₃ template 2 has been grown epitaxially by pulsed layer deposition on a release-layer covered <100> oriented SrTiO₃ single crystal (at 900 C in 10⁻⁵ mbar O₂ at 1 Hz of irradiation with a 248 nm excimer laser beam at a fluence of 0.8 J/cm²). The Sr₂CaAl₂O₆ -release layer has been grown to a thickness of 24 nm epitaxially by pulsed layer deposition on a <100> oriented SrTiO₃ single crystal used as master substrate 1 (at 825°C in 10⁻⁵ mbar O₂ at 1 Hz of irradiation with a 248 nm excimer laser beam at a fluence of 1.6 J/cm²). The support layer used consisted of a ~600 nm thick polymer (PMMA) film spin-coated onto the template layer before its release. The release of the layer stack from the SrTiO₃ substrate was done by immersing for 24 hours the sample into distilled water heated to 80 °C.

The following describes a further example. The carrier 5 consists of a sapphire crystal. Onto the (0001) surface of the carrier 5 a 15-nm-thick <100> oriented DyScO₃ template layer 2 is deposited. Onto this composite substrate 10 a 24-nm-thick BaTiO₃ film 8 can been grown epitaxially by the user by pulsed laser deposition (at 720 °C in 0.2 mbar O₂ at 5 Hz of irradiation with a 248 nm excimer laser beam at a fluence of 2.1 J/cm²). The DyScO₃ template 2 is grown epitaxially by pulsed layer deposition on a release-layer covered <100> oriented SrTiO₃ single crystal used as a master substrate 1 (at 880 °C in 10⁻⁵ mbar O₂ at 1 Hz of irradiation with a 248 nm excimer laser beam at a fluence of 1.0 J/cm²). The Sr₃Al₂O₆ release layer is grown to a thickness of 24 nm epitaxially by pulsed layer deposition on a <100> oriented SrTiO₃ single crystal (at 825°C in 10⁻⁵ mbar O₂ at 1 Hz of irradiation with a 248 nm excimer laser beam at a fluence of 1.6 J/cm2). The support layer used consists of a ~ 500 nm thick polymer (PMMA) film spin-coated onto the template layer before its release. The release of the layer stack from the SrTiO₃ substrate is done by immersing for 24 hours the sample into distilled water heated to 80°C.

Summarizing, the following applications of the present invention are for example conceivable.
- fabrication of novel substrates with novel surface properties or functions
- replacement of standard substrates
- large-area epitaxial coating, *e.g*., long, broad tapes, coated conductors
- high quality epitaxial coating of curved optical elements, resonators
- epitaxial growth of functional materials on CMOS chips
- complex devices that combine materials with different crystal systems on one chip
- in case the carrier or the template has a periodic structure, such as an array of grooves, the epitaxially grown film may have periodically modulated properties, *e.g*., by strain effects.
- providing an amorphous organic material with a single-crystalline surface layer for further epitaxial growth.

Furthermore conceivable are the following extensions of the present invention.
- Stacking multiple crystalline layers with epitaxially grown and possibly structured films, 3D manufacturing.
- The films or heterostructures to be grown onto the composite substrates do not have to be grown epitaxially.
   **a)** the template layer than is achievable by remote epitaxy, in which the carrier-2D layer-template stack system is incoherent.
   **b)** The epitaxially grown template layers (e.g. oxides) comprise a far larger number of compounds, of which many are chemically more robust and versatile than 2D materials such as graphene.

In addition, while a particular feature or aspect of an embodiment of the disclosure may have been disclosed with respect to only one of several implementations, such feature or aspect may be combined with one or more other features or aspects of the other implementations as may be desired and advantageous for any given or particular application. Furthermore, to the extent that the terms "include", "have", "with", or other variants thereof are used in either the detailed description or the claims, such terms are intended to be inclusive in a manner similar to the term "comprise". Furthermore, it should be understood that embodiments of the disclosure may be implemented in discrete circuits, partially integrated circuits or fully integrated circuits or programming means. Also, the term "exemplary" is merely meant as an example, rather than the best or optimal. It is also to be appreciated that features and/or elements depicted herein are illustrated with particular dimensions relative to one another for purposes of simplicity and ease of understanding, and that actual dimensions may differ substantially from that illustrated herein.

Although specific embodiments have been illustrated and described herein, it will be appreciated by those of ordinary skill in the art that a variety of alternate and/or equivalent implementations may be substituted for the specific embodiments shown and described without departing from the scope of the present disclosure. This application is intended to cover any adaptations or variations of the specific embodiments discussed herein. Therefore, it is intended that this disclosure be limited only by the claims and the equivalents thereof.

## Claims

1. A method for fabricating a composite substrate (10), the method comprising
- providing a first crystalline layer (2);
- providing a carrier (5);
- fabricating a composite substrate (10) by attaching the first crystalline layer (2) on the carrier (5).

2. The method according to claim 1, wherein
- providing the first crystalline layer (2) comprises
- providing a master substrate (1);
- depositing the first crystalline layer (2) on or above the master substrate (1); and
- separating the first crystalline layer (2) from the master substrate (1).

3. The method according to claim 2, further comprising fabricating a plurality of composite substrates (10) by repeatedly re-using one and the same master substrate (1) for fabricating a plurality of first crystalline layers (2) and subsequently attaching the plurality of first crystalline layers (2) on a corresponding plurality of carriers (5).

4. The method according to claim 2 or 3, further comprising
- depositing a release layer (3) on or above the master substrate (1) and subsequently depositing the first crystalline layer (2) on or above the release layer (3); wherein
- separating the first crystalline layer (2) from the master substrate (1) comprises removing the release layer (3) from the master substrate (1).

5. The method according to any one of the preceding claims, further comprising
depositing at least one blocking layer (7) on or above the master substrate (1).

6. The method according to claims 4 and 5, further comprising depositing the at least one blocking layer (7) on the release layer (3) and subsequently depositing the first crystalline layer (2) on or above the blocking layer (7).

7. The method according to any one of the preceding claims, wherein
providing a first crystalline layer (2) comprises providing a layer stack (2, 4) comprising a support layer (4) and the first crystalline layer (2) attached to the support layer (4); and
fabricating a composite substrate (10) comprises attaching the layer stack (2, 4) on the carrier (5).

8. The method according to any one of the preceding claims, wherein
- fabricating a composite substrate (10) comprises disposing one or both of an adhesion layer (6) and a blocking layer (7) on the carrier (1) and thereafter attaching the first crystalline layer (2) or the layer stack (2, 4) on the adhesion layer (6) or the blocking layer (7).

9. The method according to any one of the preceding claims, further comprising
epitaxially depositing a second crystalline layer (8) onto the first crystalline layer (2) of the composite substrate (10) .

10. A composite substrate (10) comprising
- a carrier (5); and
- a first crystalline layer (2) attached to the carrier (5), a material of the first crystalline layer (2) being different from a material of the carrier (5).

11. The composite substrate (10) according to claim 10, further comprising
- an adhesion layer (6) disposed between the carrier (1) and the first crystalline layer (2).

12. The composite substrate (10) according to claim 10 or 11, further comprising
- a blocking layer (7) disposed between the carrier (5) and the first crystalline layer (2) and configured to reduce interdiffusion of atomic species or electronic or magnetic interactions between the carrier (5) and the first crystalline layer (2).

13. The composite substrate (10) according to any one of claims 10 to 12, further comprising
- a second crystalline layer (8) epitaxially grown on the first crystalline layer (2).

14. The composite substrate (10) according to claim 13, wherein
the first crystalline layer (2) and the second crystalline layer (8) comprise identical or structurally or chemically related materials.

15. A method for providing a crystalline layer, the method comprising:
- providing a master substrate (1);
- depositing a crystalline layer (2) on or above the master substrate (1); and
- separating the crystalline layer (2) from the master substrate (1).

16. The method according to claim 15, further comprising
- depositing a release layer (3) on the master substrate (1) and subsequently depositing the crystalline layer (2) on the release layer (3); and
- separating the crystalline layer (2) from the master substrate (1) by removing the release layer (3).

17. The method according to claim 15 or 16, further comprising
depositing at least one blocking layer (7) on or above the master substrate (1).

18. The method according to claims 16 and 17, further comprising
depositing the at least one blocking layer (7) on the release layer (3) and subsequently depositing the first crystalline layer (2) on or above the blocking layer (7).

19. The method according to any one of claims 15 to 18, further comprising
- fabricating a layer stack (2, 4) by disposing a support layer (4) on the crystalline layer (2); wherein
- separating the crystalline layer (2) comprises separating the layer stack (2, 4) from the master substrate (1).

20. The method according to any one of claims 15 to 19, wherein
- disposing the crystalline layer (2) comprises choosing a material of the crystalline layer (2) based on one or more of an internal requirement, a personal wish by someone, an external requirement, an order or a request of a friend, business partner or customer.

21. The method according to claim 20, further comprising
- handing over or delivering the separated crystalline layer (2) or layer stack (2, 4) to one or more of a person, entity, company, or customer who had placed the order or request.

22. The method according to any one of claims 16 to 21, wherein
- depositing the release layer (3) comprises epitaxially depositing the release layer (3) onto the master substrate (1).

23. The method according to any one of claims 15 to 22, wherein
- depositing the crystalline layer (2) comprises epitaxially depositing the crystalline layer (2) on the master substrate (1) or on the release layer (3).

24. The method according to claims 15 to 23, wherein
a thickness of the crystalline layer (2) is in a range from 1 crystalline unit cell to 500 nm or from 1 nm to 50 nm or from 5 nm to 50 nm.

25. The method according to any one of claims 16 to 24, wherein
the release layer (3) and the crystalline layer (2) comprise lattice constant projections that differ by less than 10% or by less than 5%.
